**Europäisches Patentamt**

**European Patent Office**

**Office européen des brevets**

(11) Veröffentlichungsnummer : **0 503 141 A1**

## (12) EUROPÄISCHE PATENTANMELDUNG

(21) Anmeldenummer : **91119575.8**

(22) Anmeldetag : **16.11.91**

(51) Int. Cl.⁵ : **H01L 43/06**, H01L 29/06

(30) Priorität : **15.03.91 CH 790/91**

(43) Veröffentlichungstag der Anmeldung :
**16.09.92 Patentblatt 92/38**

(84) Benannte Vertragsstaaten :
**AT CH DE ES FR GB GR IT LI NL SE**

(71) Anmelder : **Landis & Gyr Betriebs AG
CH-6301 Zug (CH)**

(72) Erfinder : **Radivoje, Popovic
Fridbach 1
CH-6300 Zug (CH)**
Erfinder : **Urs, Falk
Sinserstrasse 19
CH-6330 Cham (CH)**

(54) **Anordnung zur Eigenschaftsverbesserung von mit P/N-Uebergängen versehenen Halbleiterstrukturen.**

(57) Die Anordnung enthält ein Substrat (1), eine Halbleiterschicht (2), eine Oberflächenschicht (3), einen Halbleiterring (4), getrennte Inseln (6, 7) aus Halbleitermaterial und Anschlusskontakt-Diffusionen (5a, 5b). Die letzteren besitzen je einen elektrischen Anschluss (8a bzw. 8b). Die Halbleiterschicht (2), die Anschlusskontakt-Diffusionen (5a, 5b) und die Inseln (6,7) bestehen aus einem Halbleitermaterial eines ersten Leitfähigkeitstyps (N), während das Substrat (1), die Oberflächenschicht (3) und der Halbleiter-ring (4) aus einem Halbleitermaterial eines zweiten Leitfähigkeitstyps (P) bestehen. Entlang einer Kontaktfläche zwischen P- und N-Material mindestens eines der beiden P/N-Übergänge (1 ;2 bzw. 2 ;3) sind die Inseln (6 bzw. 7) aus Halbleitermaterial angeordnet. Die Anschlusskontakt-Diffusionen (5a, 5b) und die Inseln (6, 7) sind stark mit Fremdatomen dotiert. Die Anordnung reduziert stark den Einfluss der Spannungsabhängigkeit der Raumladungszonendicke mindestens eines Teils der P/N-Übergänge auf die Halbleiterbauelemente-Eigenschaften. Die Linearität der Spannungs/Strom-Kennlinien wird verbessert und der Einfluss einer Spannung auf die Temperaturkoeffizienten wird verringert.

Fig. 2

EP 0 503 141 A1

Die Erfindung bezieht sich auf eine Anordnung zur Eigenschaftsverbesserung von mit P/N-Übergängen versehenen Halbleiterstrukturen gemäss dem Oberbegriff des Anspruchs 1.

Die Halbleiterstrukturen sind z. B. integrierte Schaltungen. Sie enthalten mindestens ein elektrisches Halbleiterbauelement. Moderne Halbleiterstrukturen und/oder Halbleiterbauelemente sind in der Regel mit mindestens einem P/N-Übergang versehen.

Die Halbleiterbauelemente besitzen oft eine vergrabene Struktur, d. h. derjenige elektrisch aktive Teil eines Halbleitermaterials, aus dem das Halbleiterbauelement hergestellt ist, ist mit einer an der Oberfläche der zugehörigen Halbleiterstruktur angeordneten Oberflächenschicht bedeckt. Die letztere bildet dabei an ihrer Kontaktfläche mit dem aktiven Teil des Halbleitermaterials oft mindestens einen P/N-Übergang, da die Oberflächenschicht und der aktive Teil des Halbleitermaterials in der Regel aus Halbleitermaterial eines unterschiedlichen Leitfähigkeitstyps P bzw. N hergestellt sind. Die Oberflächenschicht dient z. B. der Isolierung und/oder der Verbesserung der Langzeitstabilität der Halbleiterstruktur, da durch ihre Anwesenheit der Einfluss von Änderungen an der Oberfläche der Halbleiterstruktur auf die Eigenschaften der Halbleiterstruktur-Bauelemente reduziert oder sogar verhindert wird. Oberflächenschichten der genannten Art sind in der US-PS 4 929 993 beschrieben. Wie dort ersichtlich bestehen die Oberflächenschichten aus Halbleitermaterial eines bestimmten Leitfähigkeitstyps P oder N, welches entweder mittels einer Diffusion oder Implantation von Fremdatomen in eine Halbleiterschicht hergestellt oder im Betrieb, mittels elektrischer Influenz, durch Anlegen einer elektrischen Spannung an kapazitiv aufgebauten Oberflächenschichten der Halbleiterstruktur erzeugt wird.

Ausserdem ist der aktive Teil des Halbleitermaterials oft, in Bipolarschaltungen immer, auf einem Substrat vom entgegengesetzten Leitfähigkeitstyp aufgetragen und/oder ein Halbleiterstruktur-Bauelement zwecks elektrischer Isolierung desselben gegenüber benachbarten Halbleiterbauelementen mittels eines Halbleiterringes vom entgegengesetzten Leitfähigkeitstyp umgeben, was in der Halbleiterstruktur weitere P/N-Übergänge ergibt.

Bestimmte elektrische Eigenschaften von solchen oder anderen P/N-Übergängen aufweisenden Halbleiterbauelementen, wie z. B. deren Linearität und/oder Temperaturabhängigkeit, sind von den Raumladungszonendicken abhängig, die entlang der verschiedenen P/N-Übergänge vorhanden sind. Die Dicke und Ausdehnung der Raumladungszonen, die bekanntlich an Ladungsträgern verarmte Zonen sind, sind von der Grösse der angelegten elektrischen Spannung abhängig. Die Spannungsabhängigkeit der bei P/N-Übergängen vorhandenen Raumladungszonendicken wird als "Junction field effect" (JFE) bezeichnet.

Der Erfindung liegt die Aufgabe zugrunde, eine Anordnung zu verwirklichen, welche den Einfluss der Spannungsabhängigkeit der Raumladungszonendicke mindestens eines Teils der P/N-Übergänge auf die Halbleiterbauelemente-Eigenschaften stark reduziert. Im besonderen soll dadurch jeweils die Linearität der Spannungs/Strom-Kennlinien verbessert und der Einfluss einer angelegten Spannung auf die Temperaturkoeffizienten der Halbleiterbauelemente verringert werden. Bei Hallelementen wird ausserdem die Linearität der Hallspannung in Funktion eines Speisesestromes und/oder eines Magnetfeldes verbessert.

Die genannte Aufgabe wird erfindungsgemäss durch die im Kennzeichen des Anspruchs 1 angegebenen Merkmale gelöst.

Vorteilhafte Ausgestaltungen der Erfindung ergeben sich aus den Unteransprüchen.

Ausführungsbeispiele der Erfindung sind in der Zeichnung dargestellt und werden im folgenden näher beschrieben.

Es zeigen:

Fig. 1 einen vertikalen Querschnitt einer ersten Variante eines Halbleiterwiderstandes oder eines horizontalen Hallelementes,

Fig. 2 einen vertikalen Querschnitt einer zweiten Variante eines Halbleiterwiderstandes oder eines horizontalen Hallelementes,

Fig. 3 einen zu den Figuren 1 und 2 gehörenden horizontalen Querschnitt eines Halbleiter widerstandes,

Fig. 4 einen zu den Figuren 1 und 2 gehörenden horizontalen Querschnitt eines horizontalen Hallelementes,

Fig. 5 einen vertikalen Querschnitt einer ersten Variante eines vertikalen Hallelementes,

Fig. 6 einen vertikalen Querschnitt einer zweiten Variante eines vertikalen Hallelementes,

Fig. 7 einen zu den Figuren 5 und 6 gehörenden horizontalen Querschnitt einer ersten Untervariante des vertikalen Hallelementes und

Fig. 8 einen zu den Figuren 5 und 6 gehörenden horizontalen Querschnitt einer zweiten Untervariante des vertikalen Hallelementes.

Aus Gründen der zeichnerischen Klarheit sind die Figuren nicht massstabgetreu. Gleiche Bezugszahlen bezeichnen in allen Figuren der Zeichnung gleiche Teile.

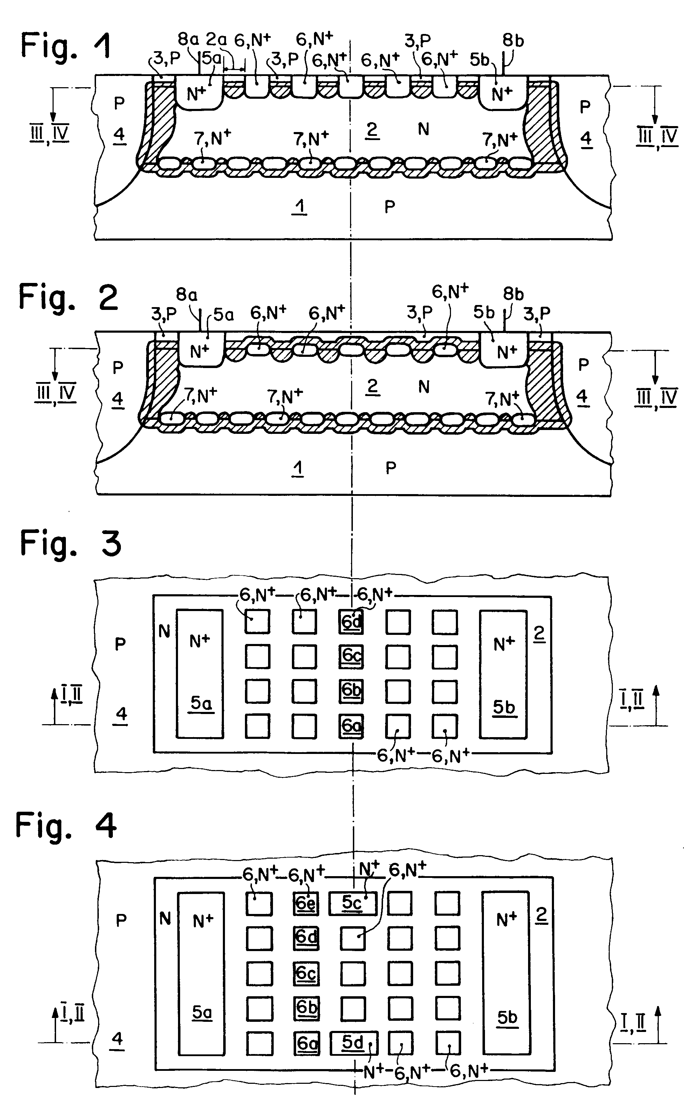

Die in den Figuren 1 bis 8 dargestellten erfindungsgemässen Anordnungen enthalten je ein Substrat 1, auf dessen Oberfläche eine Halbleiterschicht 2, vorzugsweise eine Epitaxie-Schicht, aufgetragen ist, die ihrerseits an ihrer dem Substrat 1 abgewandten Oberfläche mit einer Oberflächenschicht 3 bedeckt ist, sowie einen Halbleiterring 4.

Die Halbleiterstrukturen enthalten Halbleiterbauelemente, die je einen aktiven Teil aufweisen, der sich jeweils innerhalb der Halbleiterschicht 2 befindet und aus einem Halbleitermaterial eines ersten Leitfähigkeitstyps besteht.

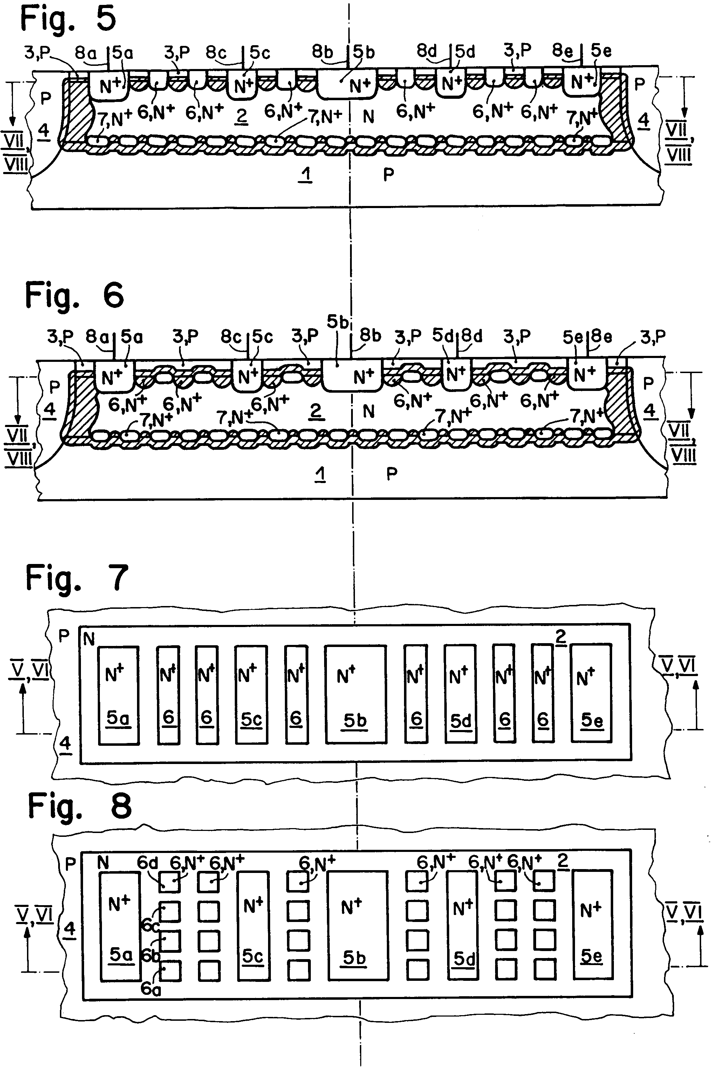

In der Zeichnung gilt aus Gründen der zeichnerischen Einfachheit immer die Annahme, dass die Halbleiterstruktur jeweils nur aus einem einzigen Halbleiterbauelement besteht, und zwar als Beispiel in den Figuren 1 bis 3 aus einem Halbleiterwiderstand, in den Figuren 1, 2 und 4 aus einem sogenannten horizontalen Hallelement und in den Figuren 5 bis 8 aus einem sogenannten vertikalen Hallelement. Horizontale Hallelemente messen bekanntlich Magnetfelder, die senkrecht zu ihrer Oberfläche ausgerichtet sind. Ihr Aufbau sowie ihre Arbeitsweise ist unter anderem aus der US-PS 4 253 107 bekannt. Vertikale Hallelemente messen dagegen bekanntlich Magnetfelder, die parallel zu ihrer Oberfläche ausgerichtet sind. Ihr Aufbau und ihre Arbeitsweise ist unter anderem aus der US-PS 4 782 375 bekannt.

Der Halbleiterring 4 umgibt jeweils seitlich denjenigen aktiven Teil der Halbleiterschicht 2, in dem das betreffende Halbleiterbauelement, also der Halbleiterwiderstand bzw. eines der Hallelemente, enthalten ist. Er besitzt in seinem unteren Teil mindestens Kontakt mit dem Substrat 1 oder er dringt dort sogar, wie in der Zeichnung dargestellt, in das Substrat 1 ein.

Das Substrat 1, die Oberflächenschicht 3 und der Halbleiterring 4 bestehen aus einem Halbleitermaterial eines zweiten Leitfähigkeitstyps. In der Zeichnung wurde angenommen, dass N der erste und P der zweite Leitfähigkeitstyp ist. Die Kontaktfläche zwischen dem Substrat 1 und der Halbleiterschicht 2 bildet einen ersten P/N-Übergang 1;2. Die Kontaktfläche zwischen der Halbleiterschicht 2 und der Oberflächenschicht 3 bildet einen zweiten P/N-Übergang 2;3.

Halbleiterbauelemente weisen in der Regel an ihrer Oberfläche mehrere Anschlusskontakt-Diffusionen auf, die, falls eine Oberflächenschicht 3 vorhanden ist, von der Oberfläche ausgehend die Oberflächenschicht 3 durchqueren, um anschliessend in die Halbleiterschicht 2 einzudringen zwecks Bildung eines elektrischen Kontaktes mit dem elektrisch aktiven Teil der Halbleiterschicht 2. Das eigentliche Halbleiterbauelement wird dann durch diesen aktiven Teil der Halbleiterschicht 2 gebildet.

Der in den Figuren 1 bis 3 dargestellte Halbleiterwiderstand besitzt zwei Anschlusskontakt-Diffusionen 5a und 5b, das in den Figuren 1, 2 und 4 dargestellte horizontale Hallelement vier Anschlusskontakt-Diffusionen 5a, 5b, 5c und 5d und das in den Figuren 5 bis 8 dargestellte vertikale Hallelement fünf Anschlusskontakt-Diffusionen 5a, 5b, 5c, 5d und 5e.

In der Zeichnung wurde beim Halbleiterwiderstand (siehe Fig. 3) und beim vertikalen Hallelement (siehe Fig. 7 und Fig. 8) das ausschliessliche Vorhandensein von in der Draufsicht länglichen Anschlusskontakt-Diffusionen 5a und 5b bzw. 5a bis 5e angenommen, deren Längsachsen alle parallel zueinander ausgerichtet sind. Die beiden Anschlusskontakt-Diffusionen 5a und 5b des Halbleiterwiderstandes und die fünf Anschlusskontakt-Diffusionen 5a, 5c, 5b, 5d und 5e des vertikalen Hallelementes sind, in der Darstellung der Zeichnung und in der angegebenen Reihenfolge, von links nach rechts in einer Richtung senkrecht zu ihren Längsachsen parallel nebeneinander angeordnet. Dabei ist beim vertikalen Hallelement eine senkrecht zur Oberfläche verlaufende und durch das Zentrum der Anschlusskontakt-Diffusion 5b führende Achse vorzugsweise eine Symmetrieachse des Hallelementes.

In der Zeichnung wurde beim horizontalen Hallelement (siehe Fig. 4) das Vorhandensein von zwei in der Draufsicht länglichen Anschlusskontakt-Diffusionen 5a und 5b angenommen, deren Längsachsen parallel zueinander ausgerichtet sind. Die vier Anschlusskontact-Diffusionen 5a, 5b, 5c und 5d des horizontalen Hallelementes sind zwei zu zwei über Kreuz angeordnet, d. h. in dem in der Fig. 4 dargestellten querschnitt verläuft die Verbindungslinie der Zentren der beiden Anschlusskontakt-Diffusionen 5a und 5b senkrecht zur Verbindungslinie der Zentren der beiden Anschlusskontakt-Diffusionen 5c und 5d. Die beiden Verbindungslinien sind dabei vorzugsweise Symmetrieachsen des horizontalen Hallelementes.

Zwecks Realisierung guter ohmscher Kontakte bestehen die Anschlusskontakt-Diffusionen 5a bis 5e vorzugsweise aus stark mit Fremdatomen dotiertem Halbleitermaterial des ersten Leitfähigkeitstyps N, d. h. aus $N^+$-Halbleitermaterial.

Entlang mindestens einer Kontaktfläche zwischen dem, den aktiven Teil der Halbleiterbauelemente enthaltenden Halbleitermaterial und einem Halbleitermaterial des zweiten Leitfähigkeitstyps P, d.h. entlang einer Kontaktfläche zwischen P- und N-Material mindestens eines der P/N-Übergänge 1;2 oder 2;3, sind getrennte Inseln 6 bzw. 7 aus stark mit Fremdatomen dotiertem Halbleitermaterial des ersten Leitfähigkeitstyps angeordnet. Die Inseln 6 und 7 bestehen somit in der Zeichnung alle aus $N^+$-Halbleitermaterial. Eine der Halbleiterschichten, entlang deren Kontaktfläche die Inseln 6 bzw. 7 mindestens angeordnet sind, ist somit vorzugsweise das Substrat 1 oder die Oberflächenschicht 3. In der Zeichnung wurde angenommen, dass die Inseln 6 bzw. 7 sowohl entlang des P/N-Überganges 1;2 als auch entlang des P/N-Übergangs 2;3 vorhanden sind.

Die Konzentration der Fremdatome im N-Halbleitermaterial und im P-Halbleitermaterial des Substrates 1 ist vorzugsweise $10^{14}$ bis $10^{15}$ cm$^{-3}$, diejenige im P-Halbleitermaterial der Oberflächenschicht 3 vorzugsweise gleich $10^{16}$ bis $10^{17}$ cm$^{-3}$ und diejenige im N$^+$-Halbleitermaterial vorzugsweise grösser oder annähernd gleich $10^{17}$ cm$^{-3}$.

Alle Anschlusskontakt-Diffusionen 5a bis 5e besitzen je einen elektrischen Anschluss 8a, 8b, 8c, 8d bzw. 8e, der aus einer Metallisierung oder, wie in der Zeichnung dargestellt, aus einer Drahtverbindung, z. B. einem "Bond"-Draht, bestehen kann. Die elektrischen Anschlüsse 8a bis 8e sind die äusseren Anschlüsse des betreffenden Halbleiterbauelementes. Bei den Hallelementen bilden die Anschlüsse 8c und 8d jeweils die Sensorelektroden und die Anschlüsse 8a und 8b beim horizontalen Hallelement bzw. 8a, 8b und 8e beim vertikalen Hallelement die Stromelektroden.

Die Inseln 6 und 7 weisen vorzugsweise keinen elektrischen Anschluss auf. Zwischen den Inseln 6 und 7 und dem anderen stark mit Fremdatomem dotierten Halbleitermaterial des Halbleiterbauelementes ist jeweils vorzugsweise kein unmittelbarer Kontakt vorhanden.

In der in den Figuren 1 und 5 dargestellten Variante der Halbleiterbauelemente sind die entlang des zweiten P/N-Übergangs 2;3 angeordneten Inseln 6 jeweils so ausgebildet, dass sie die Oberflächenschicht 3 bis zum Erreichen von deren Oberfläche durchqueren. In der in den Figuren 2 und 6 dargestellten Variante der Halbleiterbauelemente sind dagegen diese Inseln 6 jeweils so ausgebildet, dass sie nur vergraben beiderseits der Kontaktfläche zwischen der Halbleiterschicht 2 und der Oberflächenschicht 3 vorhanden sind und somit die Oberfläche der Oberflächenschicht 3 nicht erreichen.

In allen Varianten ist zwischen zwei in einem Querschnitt benachbarten Anschlusskontakt-Diffusionen jeweils mindestens eine der Inseln 6 vorhanden. In der Fig. 7 sind z. B. zwischen den Anschlusskontakt-Diffusionen 5a und 5c sowie 5d und 5e je zwei Inseln 6 vorhanden, während zwischen den Anschlusskontakt-Diffusionen 5c und 5b sowie 5b und 5d nur je eine Insel 6 angeordnet ist.

In der Zeichnung sind immer mindestens zwei der Anschlusskontakt-Diffusionen 5a bis 5e länglich und weisen parallele Längsachsen auf. In diesem Fall sind die Inseln 6 in einer in der Fig. 7 dargestellten Untervariante vorzugsweise ebenfalls länglich und ihre Längsachsen dann parallel zu den Längsachsen der länglichen Anschlusskontakt-Diffusionen 5a bis 5e angeordnet.

In einer weiteren, in den Figuren 3, 4 und 8 dargestellten Untervariante der Halbleiterbauelemente sind dagegen, bei anwesenden länglichen Anschlusskontakt-Diffusionen, mehrere in der Draufsicht annähernd quadratische Inseln vorhanden, z. B. die Inseln 6a bis 6d (siehe Fig. 3 und Fig. 8) bzw. 6a bis 6e (siehe Fig. 4), die in einer Richtung parallel zu den Längsachsen der länglichen Anschlusskontakt-Diffusionen parallel nebeneinander angeordnet sind. In der Fig. 3 sind z. B. fünf Kolonnen zu je vier quadratischen Inseln 6 parallel zueinander und parallel zu den länglichen Anschlusskontakt-Diffusionen 5a und 5b zwischen den letzteren angeordnet. In der Fig. 4 sind z. B. vier Kolonnen zu je fünf quadratischen Inseln 6 sowie eine Kolonne zu drei quadratischen Inseln 6 parallel zueinander und parallel zu den länglichen Anschlusskontakt-Diffusionen 5a und 5b zwischen den letzteren angeordnet. Dabei enthält die mittlere Kolonne neben ihren drei quadratischen Inseln 6 noch die beiden Anschlusskontakt-Diffusionen 5c und 5d. In der Fig. 3 sind z. B. fünf Kolonnen zu je vier quadratischen Inseln 6 parallel zueinander und parallel zu den länglichen Anschlusskontakt-Diffusionen 5a und 5b zwischen den letzteren angeordnet. In der Fig. 8 sind z. B. zwischen den Anschlusskontakt-Diffusionen 5a und 5c sowie 5d und 5e je zwei Kolonnen zu je vier quadratischen Inseln 6 und zwischen den Anschlusskontakt-Diffusionen 5c und 5b sowie 5b und 5d je eine Kolonnen zu je vier quadratischen Inseln 6 parallel zueinander und parallel zu den länglichen Anschlusskontakt-Diffusionen 5a bis 5e angeordnet.

Die Inseln 7 können unabhängig von den Inseln 6 ähnlich ausgebildet und/oder angeordnet sein, wie die in der Zeichnung dargestellten Anordnungen der Inseln 6, mit dem Unterschied, dass sie ohne Rücksicht auf die Anschlusskontakt-Diffusionen 5a bis 5e mehr oder weniger regelmässig entlang des ersten P/N-Übergangs 1;2 angeordnet werden können. Sie können somit unter anderem ebenfalls länglich oder quadratisch ausgebildet sein.

Entlang der verschiedenen P/N-Übergänge sind Raumladungszonen vorhanden, deren Querschnitte in den Figuren 1, 2, 5 und 6 schraffiert dargestellt sind. Durch eine starke Dotierung mindestens eines der beiden Halbleitermaterialien, deren Kontaktflächen einen P/N-Übergang bilden, wird die Ausdehnung, d. h. die Dicke der zugehörigen Raumladungszone im betreffenden stark dotierten Halbleitermaterial sehr klein gehalten. Die innerhalb des N$^+$-Halbleitermaterials vorhandenen Raumladungszonen sind daher sehr dünn, so dass sie in den Figuren 1, 2, 5 und 6 vernachlässigt und nicht dargestellt werden können. Ebenso können die Raumladungszonen innerhalb des P-Halbleitermaterials der P/N$^+$-Übergänge der Oberflächenschicht 3 vernachlässigt und nicht dargestellt werden, da die Oberflächenschicht 3, obwohl deren Halbleitermaterial auch mit P bezeichnet ist, im Vergleich zum Substrat 1 relativ stark dotiert ist.

Beim Vorhandensein von stark mit Fremdatomen dotierten Inseln 6 oder 7 des ersten Leitfähigkeitstyps N entlang des P/N-Übergangs 2;3 bzw. 1;2 stellen die Inseln 6 oder 7, sobald die Raumladungszone des zugehörigen P/N-Überganges 2;3 bzw. 1;2 im Halbleitermaterial des ersten Leitfähigkeitstyps N, d. h. in der Halbleiterschicht 2, eine Tiefe der Grössenordnung a erreicht hat, Ladungen für den weiteren Aufbau der betreffenden Raumladungszone zur Verfügung und verhindern dadurch ein weiteres Anwachsen dieser Raumladungszone innerhalb des Halbleitermaterials des ersten Leitfähigkeitstyps N über die Tiefe a hinaus, wenn a den zum P/N-Übergang 2;3 bzw. 1;2 parallel gemessenen halben Abstand zwischen zwei benachbarten zugehörigen Inseln 6 bzw. 7 bezeichnet (siehe Fig. 1). Durch die Wahl eines kleinen Wertes von a, vorzugsweise in der Grössenordnung von 1μ, wird somit die Dicke der Raumladungszone in der Halbleiterschicht 2 klein gehalten.

Da ein stark mit Fremdatomen dotiertes Halbleitermaterial der Inseln 6 und 7 einen Kurzschluss darstellt, der einen Teil des aktiven Halbleitermaterials der Halbleiterschicht 2 überbrückt, sind vorzugsweise mindestens zwei der drei Dimensionen der Inseln 6 und 7 möglichst klein zu wählen, damit die negativen Auswirkungen der zugehörigen Kurzschlüsse minimiert werden. Es sind somit möglichst viele kleine, einen möglichst geringen Abstand 2a zwischen benachbarten Inseln aufweisende Inseln 6 oder 7 entlang des betreffenden P/N-Übergangs 2;3 bzw. 1;2 anzuordnen.

Durch eine geschickte Wahl der Abmessungen, der Abstände und der Dotierung der Inseln 6 und/oder 7 kann somit erreicht werden, dass eine durch äussere Bedingungen verursachte Änderung der Raumladungszone sich nur mehr in einem Mass auswirkt, welches im interessierenden Arbeitsbereich auf die Eigenschaften der in der Halbleiterstruktur enthaltenen Halbleiterbauelemente keinen wesentlichen Einfluss mehr hat.

**Patentansprüche**

1. Anordnung zur Eigenschaftsverbesserung von mit P/N-Übergängen (1;2 bzw. 2;3) versehenen Halbleiterstrukturen, deren Halbleiterbauelemente je einen aktiven Teil aufweisen, der aus einem Halbleitermaterial eines ersten Leitfähigkeitstyps (N) besteht, dadurch gekennzeichnet, dass entlang mindestens einer Kontaktfläche zwischen dem, den aktiven Teil der Halbleiterbauelemente enthaltenden Halbleitermaterial (N) und einem Halbleitermaterial eines zweiten Leitfähigkeitstyps (P) getrennte Inseln (6, 7) aus stark mit Fremdatomen dotiertem Halbleitermaterial ($N^+$) des ersten Leitfähigkeitstyps (N) angeordnet sind.

2. Anordnung nach Anspruch 1, dadurch gekennzeichnet, dass die Inseln (6, 7) keinen elektrischen Anschluss aufweisen.

3. Anordnung nach Anspruch 1 oder 2, dadurch gekennzeichnet, dass kein unmittelbarer Kontakt vorhanden ist zwischen den Inseln (6, 7) und einem anderen, stark mit Fremdatomem dotierten Halbleitermaterial.

4. Anordnung nach einem der Ansprüche 1 bis 3, dadurch gekennzeichnet, dass eine von zwei Halbleiterschichten, entlang dessen Kontaktfläche die Inseln (6) angeordnet sind, eine Oberflächenschicht (3) der Halbleiterstruktur ist, die aus einem Halbleitermaterial des zweiten Leitfähigkeitstyps (P) besteht.

5. Anordnung nach Anspruch 4, dadurch gekennzeichnet, dass die Inseln (6) so ausgebildet sind, dass sie die Oberflächenschicht (3) bis zum Erreichen von deren Oberfläche durchqueren.

6. Anordnung nach Anspruch 4 oder 5, dadurch gekennzeichnet, dass die Halbleiterstrukturen mindestens ein elektrisches Halbleiterbauelement enthalten, welches mehrere Anschlusskontakt-Diffusionen (5a bis 5e) aufweist, die die Oberflächenschicht (3) durchqueren, und dass zwischen zwei in einem Querschnitt benachbarten Anschlusskontakt-Diffusionen jeweils mindestens eine Insel (6) vorhanden ist.

7. Anordnung nach einem der Ansprüche 4 bis 6, dadurch gekennzeichnet, dass eine weitere von zwei Halbleiterschichten, entlang dessen Kontaktfläche die Inseln (7) angeordnet sind, ein Substrat (1) ist, welches aus einem Halbleitermaterial des zweiten Leitfähigkeitstyps (P) besteht.

8. Anordnung nach einem der Ansprüche 1 bis 3, dadurch gekennzeichnet, dass eine von zwei Halbleiterschichten, entlang dessen Kontaktfläche die Inseln (7) angeordnet sind, ein Substrat (1) ist, welches aus einem Halbleitermaterial des zweiten Leitfähigkeitstyps (P) besteht.

9. Anordnung nach einem der Ansprüche 1 bis 8, dadurch gekennzeichnet, dass die Halbleiterstrukturen mindestens ein elektrisches Halbleiterbauelement enthalten, welches Anschlusskontakt-Diffusionen (5a bis 5e) aufweist, wovon mindestens zwei länglich sind und parallele Längsachsen aufweisen, und dass die Inseln (6, 7) mindestens teilweise ebenfalls länglich sind mit Längsachsen, die parallel zu den Längsachsen der länglichen Anschlusskontakt-Diffusionen (5a und 5b bzw. 5a bis 5e) angeordnet sind.

10. Anordnung nach einem der Ansprüche 1 bis 9, dadurch gekennzeichnet, dass die Halbleiterstrukturen mindestens ein elektrisches Halbleiterbauelement enthalten, welches Anschlusskontakt-Diffusionen (5a bis 5e) aufweist, wovon mindestens zwei länglich sind und parallele Längsachsen aufweisen, und dass mehrere in der Draufsicht annähernd quadratische Inseln in einer Richtung parallel zu den Längsachsen der länglichen Anschlusskontakt-Diffusionen (5a und 5b bzw. 5a bis 5e) parallel nebeneinander angeordnet sind.

11. Anordnung nach einem der Ansprüche 1 bis 10, dadurch gekennzeichnet, dass eine Halbleiterstruktur ein Hallelement ist.

Fig. 1

Fig. 2

Fig. 3

Fig. 4

# Fig. 5

# Fig. 6

# Fig. 7

# Fig. 8

Europäisches
Patentamt

# EUROPÄISCHER RECHERCHENBERICHT

Nummer der Anmeldung

EP    91 11 9575

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 244 577 (LGZ LANDIS & GYR ZUG AG) * Spalte 6, Zeile 19 - Spalte 7, Zeile 4; Abbildung 6 * --- | 1,4,6-11 | H01L43/06 H01L29/06 |
| A | GB-A-2 033 657 (BBC) * Zusammenfassung; Abbildung 1 * --- | 1-3 | |
| A | ELEKTRONIK. Bd. 32, Nr. 7, April 1983, MÜNCHEN DE Seiten 89 - 92; E. HABEKOTTE: 'Vom Transistor zum integrierten System-Bauelement' * Seite 91; Abbildung 6 * --- | 1-3 | |
| A | PATENT ABSTRACTS OF JAPAN vol. 11, no. 117 (E-498)(2564) 11. April 1987 & JP-A-61 264 771 ( MATSUSHITA ELECTRONICS CORP. ) 22. November 1986 * Zusammenfassung; Abbildungen * ----- | | |
| | | | **RECHERCHIERTE SACHGEBIETE (Int. Cl.5)** H01L |

Der vorliegende Recherchenbericht wurde für alle Patentansprüche erstellt

| Recherchenort | Abschlußdatum der Recherche | Prüfer |
|---|---|---|
| DEN HAAG | 11 JUNI 1992 | BAILLET B. |

KATEGORIE DER GENANNTEN DOKUMENTE

X : von besonderer Bedeutung allein betrachtet
Y : von besonderer Bedeutung in Verbindung mit einer
      anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
      nach dem Anmeldedatum veröffentlicht worden ist
D : in der Anmeldung angeführtes Dokument
L : aus andern Gründen angeführtes Dokument
................................................................
& : Mitglied der gleichen Patentfamilie, übereinstimmendes
      Dokument

EPO FORM 1503 03.82 (P0403)